# EUROPÄISCHE PATENTSCHRIFT

(11) **EP 3 041 138 B1**
(45) Veröffentlichungstag und Bekanntmachung des Hinweises auf die Patenterteilung: **19.08.2020**
(21) Anmeldenummer: 15188706.4
(22) Anmeldetag: 07.10.2015
(51) Int. Cl.: H03K 17/12

(54) **PARAMETRIERBARES LEISTUNGSBAUTEIL UND VERFAHREN ZU DESSEN BETRIEB**
POWER DEVICE FOR WHICH PARAMETERS CAN BE SET AND METHOD FOR OPERATING THE SAME
COMPOSANT DE PUISSANCE PARAMETRABLE ET SON PROCEDE DE FONCTIONNEMENT

(30) Priorität: 30.12.2014 DE 102014227025
(43) Veröffentlichungstag der Anmeldung: 06.07.2016
(73) Patentinhaber: Robert Bosch GmbH, 70442 Stuttgart (DE)
(72) Erfinder: Kauth, Christoph, 97816 Lohr Am Main (DE)

(56) Entgegenhaltungen:
- WO-A1-2012/123027
- WO-A1-2012/175109
- DE-A1-102011 006 788
- US-A1- 2004 195 649
- US-A1- 2004 252 430
- US-B1- 6 208 041

## Beschreibung

Die vorliegende Erfindung bezieht sich auf ein Leistungsbauteil zur Bereitstellung eines elektrischen Stromes und ein Verfahren zur Adaptierung der Leistungsfähigkeit des Leistungsbauteils an einen Anwendungsfall.

Bei vielen Anwendungen müssen mittlere und hohe Ströme mit einem Leistungsbauteil geschaltet werden. Insbesondere sind solche Anwendungen Gleichrichter aller Art z.B. in Mittelpunktschaltung, Brückenschaltung, etc.. Anwendungen dieser Art sind jedoch auch zu finden beim Widerstandsschweißen, bei Elektrofahrzeugen, bei Stromrichtern, bei Versorgungsmodulen mit Zwischenkreis usw..

DE 10 2011 006 788 A1 zeigt eine Schaltungsanordnung für eine Schutzeinrichtung für elektrische Anlagen, bei welcher eine Energiequelle EQ einen Strom liefert, der von einer zentralen Steuerlogik SL annähernd symmetrisch auf Sicherheitskanäle aufgeteilt wird. Die Stärke des am Ausgang der Schaltungsanordnung bereitgestellten elektrischen Stromes wird nicht gesteuert.

Bei Anwendungen, bei denen mittlere und hohe Ströme mit einem Leistungsbauteil geschaltet werden müssen, werden derzeit für unterschiedliche Leistungsanforderungen verschiedene Varianten mit einem speziell dafür geeigneten Schaltleistungsbauteil hergestellt. Dies erfordert einen hohen Entwicklungs- und Fertigungsaufwand sowie hohe Kosten für die Bereitstellung und Lagerung des Schaltleistungsbauteils. Ein weiterer Nachteil entsteht daraus, dass sich die Anforderungen an die Schaltung mit der Zeit verändern und daher nicht immer von vorneherein der genaue Leistungsbereich und die daher erforderliche Ausgestaltung der Schaltung bekannt ist.

Alternativ wird ein solches Schaltleistungsbauteil von Haus aus überdimensioniert realisiert und betrieben, so dass es für jeden Anwendungsfall verwendbar ist. Eine solche Lösung kann bezüglich des für die Ansteuerung erforderlichen Leistungsbedarfs und der Bauteilabmessungen nachteilig sein. Auch entstehen unnötige Kosten für das Silizium. Noch dazu ist es bei manchen Anwendungsfällen dann, wenn man sich an den Leistungsgrenzen bewegt, unumgänglich, dass die Temperaturgrenze der Bauteile ausgereizt werden muss. Dies ist zumindest im Hinblick auf die Sicherheit und die Lebensdauer des Schaltleistungsbauteils nachteilig.

Daher ist es Aufgabe der vorliegenden Erfindung, ein Leistungsbauteil zur Bereitstellung eines elektrischen Stromes und ein Verfahren zur Adaptierung der Leistungsfähigkeit des Leistungsbauteils an einen Anwendungsfall bereitzustellen, so dass die zuvor genannten Probleme gelöst werden können.

Insbesondere sollen ein Leistungsbauteil und ein Verfahren zur Adaptierung der Leistungsfähigkeit des Leistungsbauteils an einen Anwendungsfall bereitgestellt werden, so dass der Energieverbrauch minimiert werden kann und gleichzeitig die notwendigen Sicherheitsaspekte berücksichtigt werden.

Diese Aufgabe wird durch ein Leistungsbauteil zur Bereitstellung eines elektrischen Starkstromes nach Patentanspruch 1 gelöst.

Unter einem Starkstrom werden Ströme verstanden, wie sie beispielsweise beim Widerstandsschweißen, zum Antrieb von Servomotoren oder zum Betrieb von leistungsfähigen Maschinen oder zum Betrieb von Fahrzeugen verwendet werden. Es handelt sich in der Regel um Ströme im einstelligen oder zweistelligen Kiloampere-Bereich bei Spannungen > 50 Volt, vorzugsweise aus Dreiphasen-Netzen. Es kommen vor allem Anwendungen in Frage, bei denen eine Zwischenkreisspannung bereitgestellt werden muss oder eine Gleichrichtung des Stromes erforderlich wird, beispielsweise Wechselrichter und Umrichter zum Betreiben von elektrischen Motoren, auch elektrischen Fahrzeugmotoren.

Das Leistungsbauteil umfasst mindestens zwei Halbleiterstromventile, welche zueinander parallel schaltbar sind. Mindestens ein Schaltmittel ist auch umfasst zum elektronischen Parametrieren der Halbleiterstromventile durch Schalten zumindest eines der Halbleiterstromventile in einen aktiven oder passiven Zustand, um die Leistungsfähigkeit des Leistungsbauteils an einen Anwendungsfall anzupassen. Das Schaltmittel kann mehrere einzelne Schalter umfassen, welche gemeinsam oder separat mittels elektrischer Signale ansteuerbar, d.h. schaltbar sind. Unter dem Begriff Parametrieren wird verstanden, dass die Leistungsfähigkeit des Leistungsbauteils mittels der Schaltstellungen des Schaltmittels einstellbar ist. Im Rahmen der Parametrierung wird an die Steuereingänge des Schaltmittels ein Steuersignal, umfassend wenigstens zwei Bit, angelegt. Jedes Bit repräsentiert letztlich den Schaltzustand eines vom Schaltmittel umfassten Schalters und bestimmt damit, ob das diesem Schalter zugeordnete Halbleiterstromventil leitend oder nicht-leitend geschaltet ist und damit zu anderen Halbleiterstromventilen parallel betrieben wird.

Mittels der Schaltmittelzustände des Schaltmittels ist somit die Anzahl der Halbleiterstromventile einstellbar, welche parallel zur Steuerung der Stärke des Stromes betrieben werden.

Das Leistungsbauteil ermöglicht vergleichsweise kostengünstig in Herstellung und Betrieb eine Adaptierung seiner Leistungsfähigkeit an den jeweiligen Anwendungsfall. Damit ist das Leistungsbauteil sehr flexibel einsetzbar und kann flexibel auf für sich ändernde Anforderungen umparametriert werden, sogar noch während des Betriebs. Beispielsweise während eines Schweißvorganges oder während der Versorgung eines elektrischen Verbrauchers mit Starkstrom.

Somit ist es mit dem Leistungsbauteil möglich, anstelle einer Produktion einer Vielzahl von Varianten, nur noch eine Variante zu produzieren, mit der viele Anwendungsfälle abgedeckt werden können und deren Gehäuseabmessungen gleich sind. Mechanische Halterungen für das Leistungsbauteil können ebenfalls leistungsunabhängig mit identischen Abmessungen realisiert werden. Eventuelle Mehrkosten durch größere Siliziumfläche können durch höhere Stückzahlen wieder kompensiert werden. Die Variantenvielfalt wird auf ein Minimum reduziert.

Ein weiterer Vorteil des Leistungsbauteils besteht darin, dass die Temperaturgrenze der Bauteile nicht ausgereizt werden muss. Mit dem Leistungsbauteil ist ein dynamisches Verhalten des z.B. abhängig von einer Betriebstemperatur und/oder einem Leistungsbedarf realisierbar.

Vorteilhafte weitere Ausgestaltungen des Leistungsbauteils sind in den abhängigen Patentansprüchen angegeben.

Beispielsweise ist mindestens ein Anschluss vorgesehen, mittels welchem das Schaltmittel von einer Einrichtung ansteuerbar ist. Es kann sich hierbei auch um ein programmierbares Register handeln, welches den letzten Ansteuerzustand dauerhaft speichern kann und an seinem Ausgang stabil hält. Ggf. wäre eine Pufferbatterie vorzusehen. Die Anordnung ist dann derart realisiert, dass eine solche Parametrierung bei der Inbetriebnahme des Leistungsbauteils oder auch während des Betriebs vorzugsweise mittels des Parametrier-Registers vorgenommen werden kann.

Für jedes Schaltmittel bzw. jeden vom Schaltmittel umfassten Schalter ist ein Anschluss zu Entgegennahme eines elektronischen Schaltsignales zur Steuerung des Schaltzustände (Ein-/Aus) eines Schalters bereitgestellt. Jeder vom Schaltmittel umfasste Schalter ist damit einzeln mittels einer digitalen Steueranweisung (z.B. ein Nibbel/Byte/Wort) ansteuerbar. Die Steueranweisung kann von einem Mikroprozessor bereitgestellt werden (z.B. Datenbus) und/oder am Ausgang des Parametrier-Registers anliegen und/oder von einem Feldbus geliefert und vom Prozessor und/oder Parametrier-Register übernommen werden.

Besonders bevorzugt wird das Schaltmittel am Steueranschluss vorgesehen, so dass eine Ansteuerung des Halbleiterstromventil mittels seines Steueranschlusses abhängig vom Schaltzustand des Schaltmittels realisierbar ist. Ist das Schaltmittel bzw. der Schalter eingeschaltet, so kann zum Steueranschluss ein Steuerstrom bzw. eine Steuerspannung hingeführt werden und das Halbleiterstromventil gesteuert werden, d.h. in einen leitenden oder nicht-leitenden Zustand überführt werden, wobei im leitenden Zustand mittels des Steueranschlusses auch die Strommenge regulierbar ist.

Alternativ und/oder insbesondere auch zusätzlich kann das Schaltmittel am Stromeingang vorgesehen sein, so dass der Stromfluss über den Stromeingang mittels des Schaltzustandes des Schaltmittels steuerbar ist und womit die Anbindung der Halbleiterstromventile eingangsseitig an ein gemeinsames elektrisches Potential realisierbar ist. Auch eine fehlerbedingte Herausnahme eines einzelnen Halbleiterstromventils aus einer Parallelschaltung wird damit - wie später noch erläutert - ermöglicht.

Weiter alternativ und/oder insbesondere auch zusätzlich kann das Schaltmittel am Stromausgang vorgesehen sein, so dass der Stromfluss über den Stromausgang mittels des Schaltzustandes des Schaltmittesl steuerbar ist und womit die Anbindung der Halbleiterstromventile ausgangsseitig an ein gemeinsames elektrisches Potential realisierbar ist. Auch eine fehlerbedingte Herausnahme eines einzelnen Halbleiterstromventils aus einer Parallelschaltung wird damit - wie später noch erläutert - ermöglicht.

Bevorzugt ist mit mindestens ein Treiber zur Versorgung des Steueranschlusses mit einem Steuertsrom vorgesehen, wobei vorzugsweise ein elektrischer Widerstand zwischen Treiberausgang und Steueranschluss angeordnet ist. Handelt es sich bei den Halbleiterstromventilen um MOSFET-Bauteile oder IGBT-Bauteile oder dergleichen, so kann der elektrische Widerstand als Gate-Widerstand bezeichnet werden. Für diesen Gate-Widerstand wird ein Wert zwischen 1 bis 30 Ohm vorgeschlagen. Diese Werte sind im Versuch derart zu optimieren, dass sich schaltungsabhängig minimale Ein-/Ausschaltzeiten für das Halbleiterstromventil ergeben.

Ein Halbleiterstromventil kann mittels einer Halbleiterstromventilgruppe realisiert sein, wobei von einer Halbleiterstromventilgruppe mindestens zwei parallel geschaltete einzelne Stromventile umfasst sind, welche gemeinsam oder getrennt mittels eines Steueranschlusses ansteuerbar sind. Reicht die minimale Leistungsfähigkeit eines einzelnen Halbleiterstromventils nicht aus, so kann mittels dieser Vorgehensweise diese Mindest-Leistungsfähigkeit erhöht werden. Anstelle eines einzelnen Halbleiterstromventils kann somit eine Gruppe von Stromventilen parallel zu weiteren Stromventilgruppen oder einem einzelnen Halbleiterstromventil geschaltet werden.

Vorteilhafterweise wird eine Anordnung realisiert, umfassend ein erfindungsgemäßes Leistungsbauteil mit einer Einrichtung zur Steuerung des Zustandes des Schaltmittels und/oder mit einem Busanschluss zum Anschluss des Leistungsbauteils an eine externe Einrichtung zur Steuerung des Zustandes des Schaltmittels, wobei die Einrichtung zum Ausgeben eines digitalen Steuersignals an das Schaltmittel und/oder das Anschlussmittel ausgestaltet ist, zum Beispiel ein Parametrier-Register. Bei der Einrichtung handelt es sich bevorzugt um einen Mikroprozessor mit externem Datenbus, welcher vom Leistungsbauteil umfasst ist. Alternativ könnte eine Steuerung verwendet werden, welche an das Leistungsbauteil angeschlossen ist.

Der Mikroprozessor oder die Steuerung kann einen Webserver bereithalten zum Bereitstellen einer Konfigurationsoberfläche, Statusoberfläche, Wartungsoberfläche oder dergleichen zum Konfigurieren der Anzahl der aktiv geschalteten Halbleiterstromventile, und/oder der Mikrocontroller kann an den Feldbus angeschlossen sein. Die Einrichtung kann vorzugsweise mittels Internetprotokollen, vorzugsweise mittels eines Busses, drahtgebunden oder drahtlos mit übergeordneten Steuerungen kommunizieren und insbesondere Anweisungen von übergeordneten Steuerungen ausführen. Das Leistungbauteil ist somit leicht "aus der Ferne" parametrierbar.

Es ist denkbar, dass das Leistungsbauteil als Scheibenzelle ausgestaltet ist einem Transformator fixierbar oder fixiert, und/oder das Leistungsbauteil kann für einen Schweißtransformator ausgestaltet sein, um eine Parametrierbarkeit der Halbleiterstromventile im Rahmen eines Schweißprozesses bereitzustellen.

Zur Realisierung eines kompakten, widerstandsfähigen und leicht handhabbaren und parametrierbaren Leistungsbauteils wird folgende Anordnung vorgeschlagen: Eine Stromeingangsplatte zum Einspeisen eines Eingangsstroms und eine Stromausgangsplatte zur Bereitstellung eines elektrischen Starkstromes, wobei die Halbleiterstromventile zwischen der Stromeingangsplatte und der Stromausgangsplatte angeordnet sind und wobei die Stromeingänge mit der Stromeingangsplatte und die Stromausgänge mit der Stromausgangsplatte verbunden sind, wobei die Steueranschlüsse zwischen beiden Platten angeordnet sind. Die Platten bestehen vorzugsweise aus Kupfer oder einem Material mit guter Stromleitfähigkeit und Wärmeleitfähigkeit. Die Platten sind vorzugsweise im Wesentlichen, d.h. im Rahmen der üblichen Toleranzen, parallel und eng, d.h. orientiert an der Größe der innenliegenden Bauteile, beanstandet zueinander ausgerichtet.

Ein Bauteilträger kann zwischen der Stromeingangsplatte und der Stromausgangsplatte in Sandwich-Bauweise angeordnet sein, wobei vorzugsweise der Zwischenraum der Anordnung insbesondere im Randbereich verschlossen ist. Dies schützt alle Komponenten vor Beschädigung.

Die Halbleiterstromventile, die Schaltmittel, und vorzugsweise die Einrichtung und besonders bevorzugt auch das Anschlussmittel sind am Bauteilträger angeordnet, welcher Leiterbahnen umfasst, mittels derer diese Komponenten miteinander verschaltet sind. Beispielsweise kann ein Datenbus der Einrichtung mit den Schalteingängen der Schaltmittel mittelbar über das Anschlussmittel/Parametrier-Register oder unmittelbar unter Verwendung der Leiterbahnen verbunden. Hierdurch können die Komponenten leicht miteinander verbunden und sicher getragen werden.

Ganz besonders bevorzugt ist das Leistungsbauteil für die Bereitstellung eines Schweißstromes ausgebildet, um die Schweißstromstärke insbesondere auch während eines Schweißprozesses mittels des Schaltmittels veränderlich gestalten zu können. Der Schweißprozess als solcher und die Qualität der Schweißverbindungen kann damit optimiert werden. Ähnliche Optimierungen sind in anderen Anwendungen denkbar, beispielsweise die gezielte Regelung des Leistungsbedarfs bzw. bzgl. der Reduzierung der Verlustleistung.

Es bietet sich an, die Erfindung bei der Realisierung von Halbbrückenschaltungen oder Vollbrückenschaltungen oder Mittelpunktschaltungen zur Gleichrichtung oder Umrichtung oder Wechselrichtung von Strömen einzusetzen. Alle bereits genannten erfindungsgemäßen Vorteile kommen hier zum Tragen.

Es bietet sich auch an die Erfindung bei der Realisierung eines Versorgungsmoduls für Servomotoren, Gleichrichter für Widerstandsschweißanlagen oder die Energieversorgung für Elektrofahrzeuge zu verwenden. Auch hier kommen die bereits genannten Vorteile der Erfindung zum Tragen.

Die Aufgabe wird zudem durch ein Verfahren zur Adaptierung der Leistungsfähigkeit eines Leistungsbauteils an einen Anwendungsfall gemäß den unabhängigen Verfahrensansprüchen gelöst. Hierbei weist das Leistungsbauteil mindestens zwei Halbleiterstromventile auf, welche zueinander parallel schaltbar sind. Das Verfahren umfasst den Schritt: Elektronisches Parametrieren der Halbleiterstromventile durch Schalten zumindest eines der Halbleiterstromventile in einen aktiven oder passiven Zustand, mittels mindestens eines Schaltmittels, um die Leistungsfähigkeit des Leistungsbauteils an einen Anwendungsfall anzupassen, wie in den Ansprüchen beschrieben. Hierbei kann das elektronische Parametrieren über mindestens einen Anschluss des Leistungsbauteils erfolgen, über welchen das mindestens eine Schaltmittel von einer Einrichtung angesteuert wird, und wobei für jedes Schaltmittel ein Anschluss bereitgestellt ist.

Das elektronische Parametrieren kann mittels einer Einrichtung ausgeführt werden, welche vorzugsweise vom Leistungsbauteil umfasst ist.

Das Verfahren erzielt die gleichen Vorteile, wie sie zuvor in Bezug auf das Leistungsbauteil genannt sind.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Beispielsweise könnten mittels der elektronischen Parametrierung defekte Halbleiterstromventile gezielt abgeschaltet werden.

Die vorgeschlagene Lösung bietet prinzipiell auch die Möglichkeit defekte Stromventile aus der Parallelschaltung herauszutrennen. Beispielsweise könnten hierzu, wie zuvor beschrieben, in der Stromzufuhr/Stromabfuhr angeordnete Schaltmittel verwendet werden. Will man beispielsweise einem möglichen oder vorhandenen Kurzschluss eines Stromventils vorbeugen, so sollte der Schalter am Stromeingang und/oder am Stromausgang angeordnet werden. Ein Kurzschluss in einem Stromventilzweig könnte messtechnisch von einem Strommeßßmittel im Zweig erfasst und mittels der zuvor erwähnten Feldbusschnittstelle an eine Steuerung übermittelt werden. Die Steuerung könnte für Abhilfe durch Abschalten defekter und Zuschalten funktionsfähiger einzelner Stromventile sorgen. Wird der Leistungshalbleiter beispielsweise zur Realisierung der Funktion einer Widerstandsschweißdiode eingesetzt, so müsste ein laufender Fertigungsprozess bei einer oben genannten Funktionsstörung im Leistungshalbleiter ggf. nur sehr kurz oder gar nicht unterbrochen werden, was erhebliche Kosten einspart. Die Reparatur oder der Austausch des Leistungshalbleiters könnte dann auf einen späteren Zeitpunkt aufgeschoben oder ganz vermieden werden.

Auch bei Integration einer vorbeugenden Wartungsfunktion in die Anordnung (z.B. mittels des zuvor bereits erwähnten On Board Microprozessors) ist die beschriebene Vorgehensweise vorteilhaft.

Falls zum Beispiel aufgrund durchgeführter Analysen des Verhaltens der Stromventile (z.B. Vergleich von Referenzkurven, welche das Verhalten der Stromventile bei Inbetriebnahme als sog. Soll-Kurven beschreiben mit dem Ist-Verhalten im derzeitigen Betrieb) eine hohe Ausfallwahrscheinlichkeit für ein Stromventile ermittelt wird, so könnte einem Ausfall der Gesamtanordnung durch autaukes Abschalten und Ersetzen der betroffenen Stromventile mittel einer vom Leistungsbauteil vorzugsweise umfassten Einrichtung oder mittels einer mittels eines Feldbusses an das Leistungsbauteil anschließbaren externen Steuereinrichtung vollautomatisiert vorgebeugt werden, z.B. im Rahmen einer Zustandsüberwachung.

Nachfolgend ist die Erfindung unter Bezugnahme auf die beiliegenden Zeichnung und anhand von Ausführungsbeispielen näher beschrieben. Es zeigen:
Fig. 1 ein Blockschaltbild der Komponenten eines Leistungsbauteils gemäß einem ersten Ausführungsbeispiel;
Fig. 2 ein Schaltbild eines Halbleiterstromventils gemäß einem ersten Ausführungsbeispiel;
Fig. 3 ein Schaltbild einer Mittelpunktschaltung an einem Schweißtransformator, bei welchem Leistungsbauteile gemäß dem ersten Ausführungsbeispiel zum Einsatz kommen;
Fig. 4 ein Schaltbild eines Halbleiterstromventils gemäß einem zweiten Ausführungsbeispiel;
Fig. 5 ein Blockschaltbild eines Leistungsbauteil gemäß einem zweiten Ausführungsbeispiels;
Fig. 6 eine grob schematische Ansicht eines dritten Ausführungsbeispiels; und
Fig. 7 eine grob schematische Ansicht eines vierten Ausführungsbeispiels.

In den Figuren sind gleiche oder funktionsgleiche Elemente, sofern nichts anderes angegeben ist, mit identischen Bezugszeichen versehen.

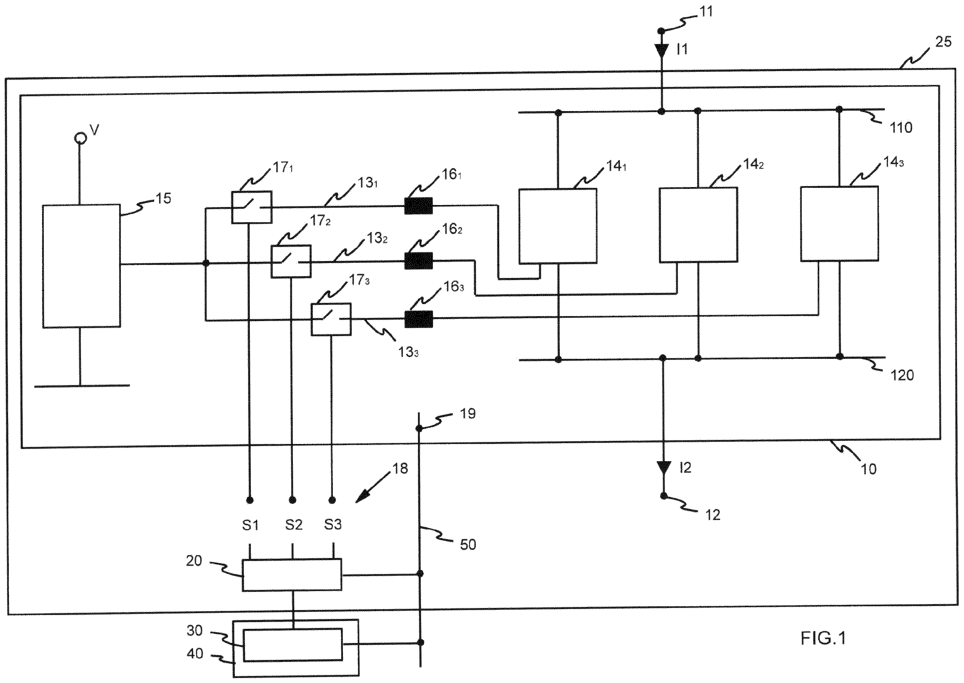

Fig. 1 zeigt ein Leistungsbauteil 10 mit einem Stromeingang 11, den ein elektrischer Eingangsstrom I1 mittels einer Stromverteilung 110 eingespeist wird, einen Stromabgang oder Stromausgang 12, aus welchem ein elektrischer Ausgangsstrom I2 von einer Stromverteilung 120 entnehmbar ist. Weiter sind gezeigt, Steueranschlüsse 13₁, 13₂, 13₃ für Halbleiterstromventile 14₁, 14₂, 14₃, ein Treiber 15, der an eine Versorgungsspannung V angeschlossen ist, optionale Steueranschlusswiderstände 16₁, 16₂, 16₃, und Schaltmittel 17₁, 17₂, 17₃, die mit einem Steuerwort 18 von einer Einrichtung 20, vorzugsweise mittels Anschlüssen S1, S2, S3 ansteuerbar sind. Das Leistungsbauteil 10 stellt im Betrieb den einstellbaren Ausgangsstrom I2 als elektrischen Strom bereit. Das Leistungsbauteil 10 kann zudem einen Busanschluss 19 zum Anschluss des Leistungsbauteils 10 an ein Bussystem 50 zur Übertragung von Daten umfassen. Das Bussystem 50 kann ein Feldbus, wie beispielsweise Sercos gemäß der IEEE 802.3 & der ISO/IEC 8802-3, Profibus (= Process Field Bus = Prozessfeldbus), usw., oder ein sonstiger in der Automatisierung geeigneter Bus sein, der vorzugsweise echtzeitfähig ist. An das Bussystem 50 kann eine Einrichtung 20 und eine übergeordnete Steuereinrichtung 30 angebunden sein.

Die Einrichtung 20 kann beispielsweise ein Mikroprozessor oder ein sonstiges geeignetes Steuermittel sein. Die Einrichtung 20 kann zusammen mit dem Leistungsbauteil 10 auf dem gleichen Bauteilträger 25 montiert sein. Die Einrichtung 20 kann mittels einer übergeordneten Steuereinrichtung 30 angesteuert werden. Die Steuereinrichtung 30 kann beispielsweise eine zentrale Steuereinrichtung 30 einer Fertigungsanlage 40 sein, die insbesondere eine Schweißanlage sein kann.

Der Stromeingang 11 ist bei dem vorliegenden Ausführungsbeispiel mittels einer ersten Platte 110 als elektrisch leitfähige Stromeingangsplatte ausgeführt, die beispielsweise aus Metall gefertigt ist und insbesondere als Kupferplatte, usw., mit oder ohne Wasserkühlung ausgeführt sein kann.

Außerdem ist der Stromausgang 12 bei dem vorliegenden Ausführungsbeispiel mittels der zweiten Platte 120 als elektrisch leitfähige Stromausgangsplatte ausgeführt, die beispielsweise aus Metall gefertigt ist und insbesondere als Kupferplatte, usw., mit oder ohne Wasserkühlung ausgeführt sein kann. Die Platten 110, 120 für Stromeingang 11 und Stromausgang 12 können mit einem nicht leitfähigen Verbindungsmittel zwischen den Platten 110, 120 zu einer Scheibenzelle verbunden sein, auch wenn dies in Fig. 1 nicht dargestellt ist. Hierbei können auch die Anschlüsse S1, S2, S3 zwischen den Platten 110, 120 der Scheibenzelle angeordnet sein, falls erforderlich. Bei dem Leistungsbauteil 10 können also die Platten 110, 120 für den Stromeingang 11 und den Stromausgang 12 in ihrem Randbereich mittels eines elektrisch nicht leitfähigen Verbindungsmittels miteinander verbunden sein, so dass die Platten 110, 120 für Stromeingang 11 und Stromausgang 12 und das Verbindungsmittel ein Gehäuse bilden, welches das Leistungsbauteil 10 zumindest teilweise umgibt.

Bei dem Leistungsbauteil 10 sind Halbleiterstromventile 14₁, 14₂, 14₃, also Halbleiter, vorgesehen, deren Stromeingänge mit Hilfe der Platte 110 für den Stromeingang 11 miteinander verbunden sind und deren Stromausgänge mit Hilfe der Platte 120 für den Stromausgang 12 miteinander verbunden sind. Die Halbleiterstromventile 14₁, 14₂, 14₃ sind an ein gemeinsames elektrisches Potential vorzugsweise schaltbar in allen oder einigen Zweigen (nicht gezeigt) angeschlossen.

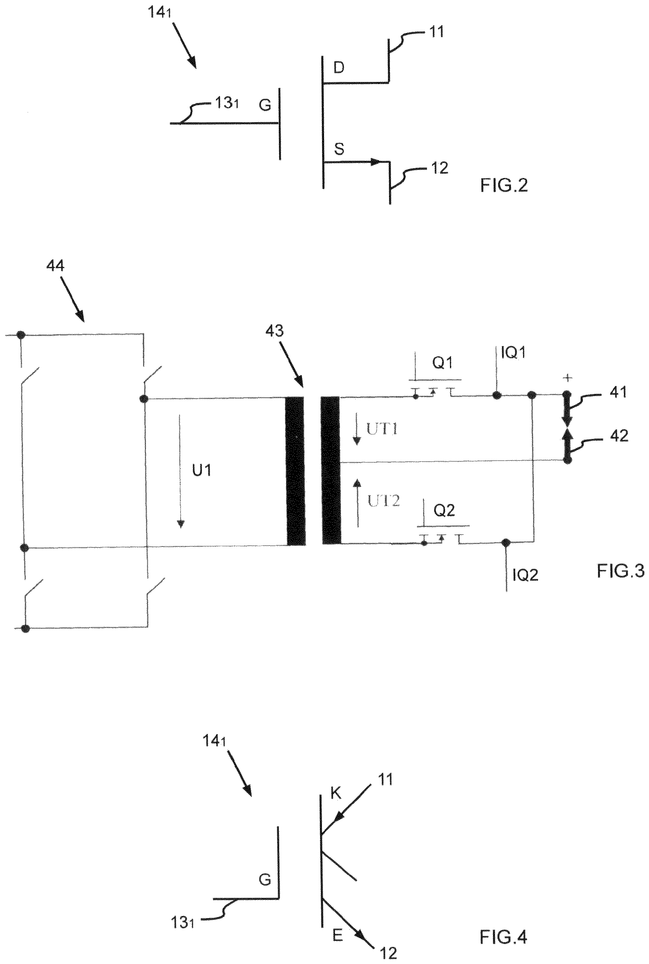

Wie in Fig. 2 gezeigt, sind die Halbleiterstromventile 14₁, 14₂, 14₃ bei dem vorliegenden Ausführungsbeispiel beispielsweise MOSFET-Bauteile (= Metall Oxid Semiconductor Field Effect Transistor = Metall-Oxid-Halbleiter-Feldeffekttransistor). Fig. 2 zeigt als Beispiel für das Halbleiterstromventil 14₁ das elektrische Schaltbild des MOSFET mit Darstellung von Gateanschluss oder Steueranschluss G, Drainanschluss D bzw. Stromeingang D und Sourceanschluss S bzw. Stromausgang S. Bei dem vorliegenden Ausführungsbeispiel aus Figur 1 werden die Halbleiterstromventile 14₁, 14₂, 14₃ jeweils mittels ihrer -Steueranschlüsse G angesteuert.

Der Treiber 15 gemäß Fig. 1 ist leistungsmäßig derart ausgelegt, dass er die Steueranschlüsse 13₁, 13₂, 13₃ der Halbleiterstromventile 14₁, 14₂, 14₃ so ansteuern kann, dass die Halbleiterstromventile 14₁, 14₂, 14₃ schnell und möglichst synchron schalten. Zwischen dem Ausgang des Treibers 15 und den Steueranschlüssen 13₁, 13₂, 13₃ ist jeweils eines der Schaltmittel 17₁, 17₂, 17₃ vorgesehen und zusätzlich vorzugsweise einer der Steueranschlusswiderstände 16₁, 16₂, 16₃. Die optimale Größe der Steueranschlusswiderstände 16₁, 16₂, 16₃ ist für den jeweiligen Fall im Versuch zu ermitteln, bewährt haben sich jedoch Werte zwischen 1 Ohm und 30 Ohm, je nach gewünschtem Verhalten des Halbleiterstromventils 14₁, 14₂, 14₃.

Jedes Schaltmittel 17₁, 17₂, 17₃ kann mittels einer logischen ja/nein-Anweisung oder digitaler ja/nein-Information über das Steuerwort 18 eingeschaltet oder ausgeschaltet bzw. geschlossen oder geöffnet werden. Jedes der Halbleiterstromventile 14₁, 14₂, 14₃ umfasst Stromeingang/Stromausgang 11, 12 und einen der Steueranschlüsse 13₁, 13₂, 13₃, mit welchem der Strom zwischen Stromeingang 11 und Stromausgang 12 steuerbar/schaltbar ist.

Die Schaltmittel 17₁, 17₂, 17₃ leiten das Signal des Treibers 15 nur dann zum jeweiligen Steueranschluss 13₁, 13₂, 13₃ weiter, wenn das zugehörige Schaltmittel 17₁, 17₂, 17₃ dies erlaubt. Je nach Schaltung kann es sich um einen Schließer oder Öffner handeln, der dies erlaubt. Der Treiber 15 kann das jeweilige Halbleiterstromventil 14₁, 14₂, 14₃ also nur dann ansteuern, sonst ist das Halbleiterstromventil 14₁, 14₂, 14₃ gesperrt und im Wesentlichen auch leistungslos.

Als Treiber 15 kämen auch Logiktreiber in Frage, welche vom Fachmann derart auszulegen sind, dass der Treiber 15 die geforderte Schaltleistung und Schaltgeschwindigkeit der Schaltmittel 17₁, 17₂, 17₃ und der Halbleiterstromventile 14₁, 14₂, 14₃ sicherstellt.

Sind mehrere der zuvor beschriebenen Anordnungen parallelgeschaltet, so erhält man eine Parallelschaltung von Halbleiterstromventilen 14₁, 14₂, 14₃, wobei die Anzahl der parallel geschalteten Halbleiterstromventile 14₁, 14₂, 14₃ mittels mehrerer digitaler ja/nein - Informationen (Bits) parametrierbar ist. Je nach Anzahl der Stufen bzw. Schaltmittel 17₁, 17₂, 17₃ entsteht eine Datenmenge aus einzelnen Bits, beispielsweise bei vier Halbleiterstromventilen 14₁, 14₂, 14₃, 14₄ ein Nibble, was 4 Bits entspricht, oder bei acht Halbleiterstromventilen 14₁, 14₂, 14₃ ... 14₈ ein Byte, was 8 Bits entspricht, oder bei 16 Halbleiterstromventilen 14₁, 14₂, 14₃ ... 14₁₆ ein Word, was 16 Bits entspricht, oder bei 32 Halbleiterstromventilen 14₁, 14₂, 14₃ ... 14₃₂ ein Double-Word, was 32 Bits entspricht. Der Fachmann ist in der Lage dies weiter auszubauen. Je mehr der zuvor genannten Anordnungen parallel geschaltet sind, desto höher und feiner ist die übertragbare Leistung des Leistungsbauteils 10 einstellbar, da sich der Strom nun auf die Halbleiterstromventile 14₁, 14₂, 14₃ ... 14₃₂ aufteilen kann.

Aufgrund der in Fig. 1 verwendeten drei Schaltmittel 17₁, 17₂, 17₃ entsteht hier beispielsweise ein 3 Bit - Steuereingang für alle Schaltmittel 17₁, 17₂, 17₃. Der 3 Bit - Steuereingang ist beispielsweise mittels eines Mikroprozessorbusses des Mikroprozessors als Einrichtung 20 ansteuerbar. Das Steuerwort 18 hat bei der Schaltung von Fig. 1 somit drei Bit.

Die Einrichtung 20 kann vorteilhaft nahe der Halbleiterstromventile 14₁, 14₂, 14₃ angeordnet sein, insbesondere auf dem gleichen Bauteilträger 25 wie das Leistungsbauteil 10, wie in Fig. 1 gezeigt.

Mittels dieser Anordnung kann unter Verwendung der übergeordneten Steuerung 30 die Parallelschaltung der Halbleiterstromventile 14₁, 14₂, 14₃ aus der Ferne, gegebenenfalls über Internet, konfiguriert werden. Denkbar wäre es auch, lokal im Speicher der Einrichtung 20 bzw. des Mikroprozessors oder Steuermittels einen Webserver zu integrieren, welcher eine Konfigurationsoberfläche bereitstellt, die von jedem handelsüblichen Browser aufrufbar ist und beispielsweise die Parametrierung der oben genannten Schaltmittel 17₁, 17₂, 17₃ ermöglicht.

Die Leistung und der Energieverbrauch der Anordnung von Fig. 1 sind bedarfsgemäß einstellbar und können gegebenenfalls während des Betriebs des Leistungsbauteils 10 eingestellt werden. Steigt der Leistungsbedarf im Betrieb des Leistungsbauteils 10, könnten mittels der übergeordneten Steuereinrichtung 30 unter Verwendung des Bussystems 50 weitere Halbleiterstromventile 14₁, 14₂, 14₃ parallel dazu geschaltet werden. Sinkt der Leistungsbedarf des Leistungsbauteils 10 wieder, so können die hinzugeschalteten Halbleiterstromventile 14₁, 14₂, 14₃ wieder abgeschaltet werden.

Eine dynamische Anpassung an die Gegebenheiten vor Ort wie die Bauteiletemperatur des Leistungsbauteils 10 und/oder die Außentemperatur und/oder geforderte Leistung und dergleichen ist somit möglich. Mit der Anzahl der parallel geschalteten Halbleiterstromventile 14₁, 14₂, 14₃ ändert sich die tatsächliche Ansteuerleistung des Leistungsbauteils 10, welche durch die vorgeschlagene Lösung nun ebenfalls beeinflussbar ist. Dadurch lässt sich mit dem Leistungsbauteil 10 gegenüber bisher bekannten Lösungen eine Energieeinsparung erzielen, weil es so konfigurierbar ist, dass diese Leistung minimal bleibt.

Die mit dem Leistungsbauteil 10 vorgeschlagene Lösung bietet prinzipiell auch die Möglichkeit, defekte Halbleiterstromventile 14₁, 14₂, 14₃ aus deren Parallelschaltung herauszutrennen. Beispielsweise könnten hierzu zusätzlich oder alternativ zum Schaltermittel-Steuereingangszweig der Schaltmittel 17₁, 17₂, 17₃ auch Schaltmittel in der Stromzufuhr/Stromabfuhr des Stromeingangs/Stromausgangs 11, 12 der Halbleiterstromventile 14₁, 14₂, 14₃ angeordnet werden. Dies ist aus Gründen der Übersichtlichkeit in Figur 1 nicht gezeigt. Will man beispielsweise einem möglichen Kurzschluss eines Halbleiterstromventils 14₁, 14₂, 14₃ vorbeugen, so sollte ein Schalter am Stromeingang 11 oder bzw. und am Stromausgang 12 dieses konkret zu überwachenden Halbleiterstromventils 14₁, 14₂, 14₃ angeordnet werden.

Ein Kurzschluss in einem Stromventilzweig könnte messtechnisch erfasst und an beispielsweise die Einrichtung 20 und/oder die Steuereinrichtung 30 oder eine andere Steuereinrichtung übermittelt werden. Die gewählte Steuereinrichtung könnte kurzfristig für Abhilfe durch Zuschalten und Abschalten einzelner Halbleiterstromventile 14₁, 14₂, 14₃ sorgen.

Wird das Leistungsbauteil 10 beispielsweise zur Realisierung der Funktion einer Widerstandsschweißdiode für eine Schweißelektrode eingesetzt, so müsste ein laufender Fertigungsprozess bei einer oben genannten Funktionsstörung im Leistungsbauteil 10 gegebenenfalls nur sehr kurz unterbrochen werden.

Auch bei Integration einer vorbeugenden Wartungsfunktion in die Anordnung, z.B. mittels der zuvor bereits erwähnten, am gleichen Bauteilträger 25 angeordneten Einrichtung 20 als Mikroprozessor, ist die beschriebene Vorgehensweise vorteilhaft. Falls zum Beispiel aufgrund durchgeführter Analysen des Verhaltens der Halbleiterstromventile 14₁, 14₂, 14₃ eine hohe Ausfallwahrscheinlichkeit für ein Halbleiterstromventil 14₁, 14₂, 14₃ ermittelt wird, könnte einem Ausfall der Gesamtanordnung durch ein Abschalten und Ersetzen der betroffenen Halbleiterstromventile 14₁, 14₂, 14₃ vollautomatisiert vorgebeugt werden. Eine solche Vorgehensweise realisiert eine proaktive Verschleißüberwachung.

Analysen des Verhaltens der Halbleiterstromventile 14₁, 14₂, 14₃ können z.B. durch Vergleich von Referenzkurven, welche das Verhalten der Halbleiterstromventile 14₁, 14₂, 14₃ bei deren Inbetriebnahme beschreiben, mit dem Ist-Verhalten der Halbleiterstromventile 14₁, 14₂, 14₃ im derzeitigen Betrieb erfolgen.

Die gesamte in Fig. 1 gezeigte Anordnung kann in einem gemeinsamen Gehäuse untergebracht sein. Wie zuvor erwähnt, kann die Anordnung somit als Scheibenzelle oder ähnlich realisiert sein, welche unmittelbar an einem Transformator in einer entsprechenden Halterung fixierbar ist. Die konfigurierbaren Leistungshalbleiter der Anordnung von Fig. 1 können zur Realisierung einer Synchron-Gleichrichterschaltung, realisiert in Mittelpunktschaltung, Brückenschaltung oder dergleichen verwendet werden.

Fig. 3 zeigt ein Beispiel für eine solche Mittelpunktschaltung für Schweißelektroden 41, 42, welche auf der Sekundärseite eines Schweißtransformators 43 durch Ströme IQ1, IQ2 der Schweißelektroden 41, 42 versorgt werden. Die Ströme IQ1, IQ2 für die Schweißelektroden 41, 42 werden von Leistungsbauteilen 10 gemäß Fig. 1 bereitgestellt. Somit entsprechen die Ströme IQ1, IQ2 für die Schweißelektroden 41, 42 jeweils dem Strom I2 des Leistungsbauteils 10 von Fig. 1. An der Sekundärseite des Schweißtransformators 43 bilden sich bei der Schaltung in Fig. 3 die zwei Spannungen UT1, UT2 aufgrund einer Primärspannung U1 des Schweißtransformators 43, welche von einem Gleichspannungszwischenkreis mit Vollbrückenschaltung 44 bereitgestellt wird.

Somit kann mit der zuvor beschriebenen Anordnung ein Verfahren zur Adaptierung der Leistungsfähigkeit des Leistungsbauteils 10 gemäß Fig. 1 an einen Anwendungsfall ausgeführt werden, wie zuvor beschrieben.

Gemäß einer Modifikation des vorliegenden Ausführungsbeispiels ist für jedes Halbleiterstromventil 14₁, 14₂, 14₃ ein eigener Treiber 15 vorgesehen. Auch bei dieser Variante sind Schaltmittel 17₁, 17₂, 17₃ zwischen dem Treiberausgang und den Steueranschlüssen 13₁, 13₂, 13₃ vorgesehen. In diesem Fall könnten jedoch auch die Treiber 15 als solche einschaltbar/abschaltbar realisiert sein.

Gemäß einer weiteren Modifikation sind, alternativ zum Einbau der Schaltmittel 17₁, 17₂, 17₃ am Ausgang des Treibers 15, die Schaltmittel 17₁, 17₂, 17₃ jedoch am Stromeingang oder Stromausgang der Halbleiterstromventile 14₁, 14₂, 14₃ angeordnet. In diesem Fall sind die Schaltmittel an dem Drainanschluss D oder dem Sourceanschluss S eines der Halbleiterstromventile 14₁, 14₂, 14₃ angeordnet. Somit ist das Schaltmittel 17₁, 17₂, 17₃ zwischen den Halbleiterstromventilen 14₁, 14₂, 14₃ in Reihe schaltbar angeordnet, so dass die Anbindung der Halbleiterstromventile 14₁, 14₂, 14₃ an ihre Versorgungsspannung V schaltbar ist. Anders ausgedrückt, die Verbindungen zwischen den Halbleiterstromventilen 14₁, 14₂, 14₃ sind im Sinne einer Reihenschaltung schaltbar realisiert, so dass die Anbindung der Halbleiterstromventile 14₁, 14₂, 14₃ an Ihre Versorgungsspannung V schaltbar wird.

Fig. 4 zeigt ein Halbleiterstromventil 14₁ gemäß einem zweiten Ausführungsbeispiel. Das Halbleiterstromventil 14₁ gemäß dem vorliegenden Ausführungsbeispiel ist, anstelle eines MOSFET-Bauteils mit Drain D, Source S und Gate G, nun ein IGBT-Bauteil (= Insulated-Gate Bipolar Transistor = Bipolartransistor mit isolierter Gate-Elektrode) mit Kollektor K 11, Emitter E 12 und Gate G 13₁. Die Halbleiterstromventile 14₂, 14₃ sind gemäß dem vorliegenden Ausführungsbeispiel ebenfalls als IGBTs ausgeführt.

Bei dem vorliegenden Ausführungsbeispiel übernehmen die IGBT-Bauteile dieselbe Funktion wie die MOSFET-Beuteile bei dem ersten Ausführungsbeispiel.

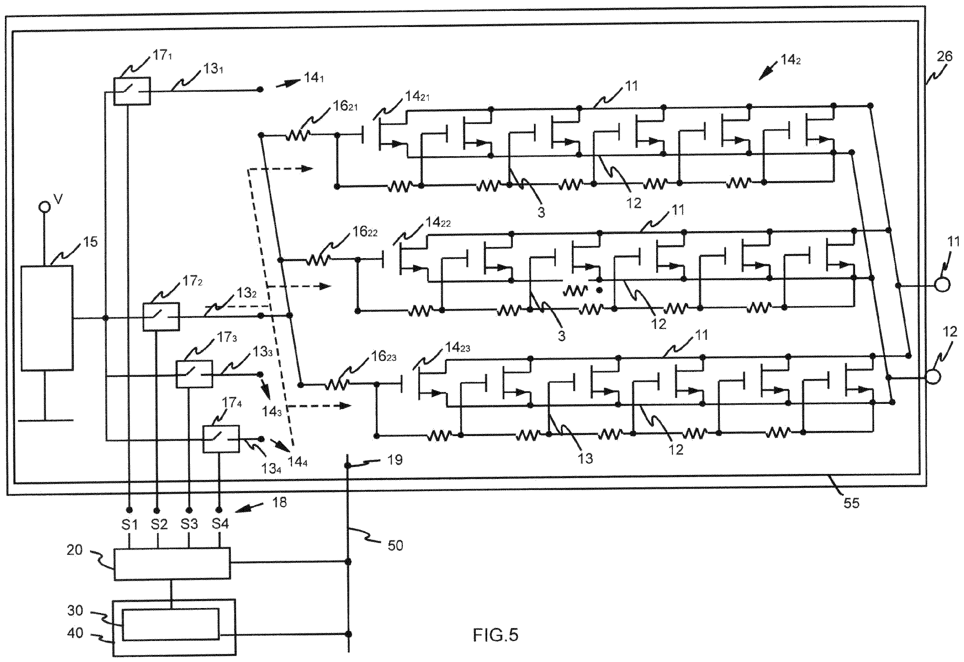

Fig. 5 zeigt ein Leistungsbauteil 55 gemäß einem zweiten Ausführungsbeispiel an einem Bauteilträger 26 angeordnet.

Es ist stellvertretend für die Halbleiterstromventile 14₁, 14₃, 14₄ nur für das Halbleiterstromventil 14₂ detailliert und schematisch gezeigt. Das Halbleiterstromventil 14₂ selbst umfasst wiederum eine Vielzahl von vorzugsweise fest miteinander verschalteten Parallelschaltungen von einzelnen Halbleiterstromventilen, welche zusammen eine Stromventilgruppe 14₂₁, 14₂₂, 14₂₃ bilden. Den Stromventilgruppen 14₂₁, 14₂₂, 14₂₃ kann jeweils einer der Widerstände 16₂₁, 16₂₂, 16₂₃ vorgeschaltet sein. Der Begriff vorzugsweise soll hier andeuten, dass die Halbleiterstromventile wiederum auch einzeln schaltbar und bevorzugt mit einem jeweils eigenen Widerstand ausgestattet sein könnten. Die einzelnen Halbleiterstromventile sind in Fig. 1 und5 jeweils MOSFET-Bauteile mit einem Stromeingang 11 und Stromausgang 12 sowie einem Steueranschluss 13, wie auch in Fig. 2 genauer gezeigt. Es könnte sich jedoch auch im IGBZ-Bauteile handeln, wie in Fig. 4 näher gezeigt. Die Halbleiterstromventile 14₁, 14₃, 14₄ werden von Steueranschlüssen 13₁, 13₂, 13₃, 14₄ angesteuert.

Insgesamt umfasst das Halbleiterstromventil 14₂ in Fig. 5 drei Stromventilgruppen 14₂₁, 14₂₂, 14₂₃, mit beispielhaft je sechs Halbleiterstromventilen. Dadurch ergibt sich, gegenüber dem Leistungsbauteil 10 gemäß dem vorangehenden Ausführungsbeispiel, die Möglichkeit einer noch weiteren feinstufigen Einstellung des Leistungsbereichs des Leistungsbauteils 55 gemäß dem vorliegenden Ausführungsbeispiel, wobei jede Halbleiterstromventilgruppe 14₂ leistungsfähiger als ein einzelnes Halbleiterstromventil ist.

Bei einem modifizierten zweiten Ausführungsbeispiel sind anstelle der festen Parallelschaltungen von hier beispielhaft gezeigten sechs Halbleiterbauteilen innerhalb der in Fig. 5 gezeigten Halbleiterstromventilgruppen 14₂₁, 14₂₂, 14₂₃ die Halbleiterstromventile innerhalb einer Halbleiterstromventilgruppe 14₂₁, 14₂₂, 14₂₃ für sich beispielsweise auch wiederum konfigurierbar miteinander verschaltet, was in den Figuren nicht gezeigt ist.

Demzufolge könnten bei Bedarf beispielsweise die einzelnen Leistungshalbleiter einer Stromventilgruppe 14₂₁ separat und unabhängig voneinander eingeschaltet oder abgeschaltet werden, wohingegen in den Stromventilgruppen 14₂₂, 14₂₃ alle Halbleiterstromventile aktiv oder inaktiv bleiben könnten.

Gemäß den beiden genannten Varianten wäre dann die Parallelschaltung der Stromventile innerhalb einer Stromventilgruppe 14₂₁, 14₂₂, 14₂₃, als auch die Parallelschaltung der Stromventilgruppen 14₂₁, 14₂₂, 14₂₃ zusätzlich vom Benutzer mittels eines Steuerwortes 18 mit Hilfe der Einrichtung 20 und bei Bedarf mittels der Steuereinrichtung 30 konfigurierbar bzw. parametrierbar.

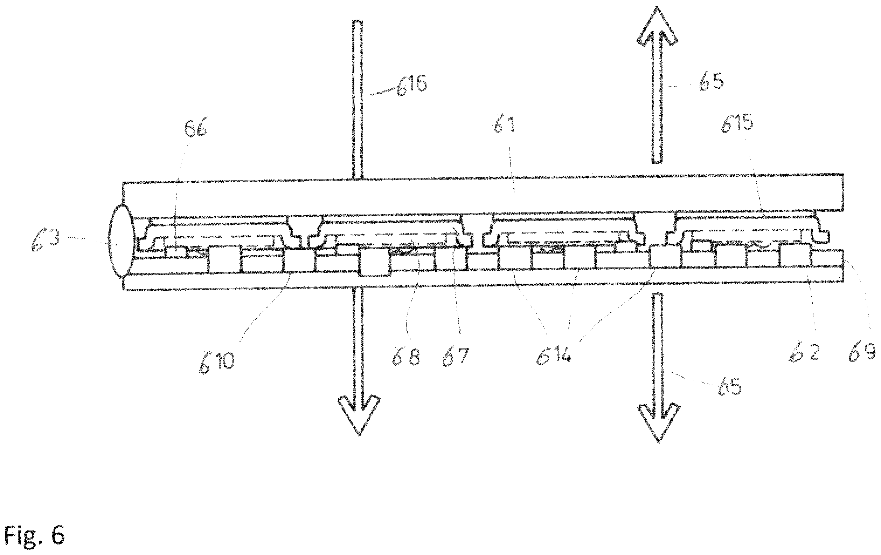

Fig. 6 zeigt ein elektrisch parametrierbares Leistungsbauteil gemäß den vorangehenden Ausführungsbeispielen. Die Anordnung umfasst hier vier Halbleiterstromventile 68. Die Anordnung umfasst zwei Platten 61, 62 bzw. eine Stromeingangsplatte 61 und eine Stromausgangsplatte 62 und einen Bauteilträger 69 in Form einer Leiterplatte.

Die Halbleiterstromventile 68 haben jeweils ein Metallgehäuse 67, welches mit dem Stromeingang des Halbleiterstromventils 68 verbunden ist. Vorzugsweise kommt ein Gehäuse 67 zum Einsatz, welches das Halbleiterstromventil 68 zumindest einseitig schützt. Der dem Stromeingang des Halbleiterstromventils 68 gegenüberliegende Stromausgang des Halbleiterstromventils 68 ist ohne Gehäuse 67 frei zugänglich ausgeführt. Ein Steueranschluss 66 ist ebenfalls gezeigt. Denkbar sind jedoch auch Halbleiterstromventile 68 ohne eigenes Gehäuse 67. Vorteilhaft ist es, wenn diese Halbleiterstromventile 68 großflächige Stromeingänge und Stromausgänge aufweisen, um die Verluste und die Leistungsdichte zu reduzieren. Zusätzlich müssen diese Halbleiter 68 zur Übertragung hoher Ströme im kA-Bereich geeignet sein.

Als elektrisch leitfähige Stromeingangsplatte 61, welche die Funktion der Stromverteilung bzw. der Platte 110 des ersten Ausführungsbeispiels übernimmt, ist eine Kupferplatte 61 vorgesehen. Als elektrisch leitfähige Stromausgangsplatte 62, welche die Funktion der Stromverteilung bzw. Platte 120 des ersten Ausführungsbeispiels übernimmt, ist ebenfalls eine Kupferplatte vorgesehen. Alternativ käme neben Kuper als Material für die Platten 61, 62 auch Molybdän in Frage. Die gewählten Materialien sollten eine gute Strom- und Wärmeleitfähigkeit und eine ähnliche thermische Ausdehnung wie Silizium aufweisen. Die Stärke der Platten 61, 62 kann beispielsweise im Millimeterbereich liegen (z.B. 2 mm).

Bei dem in Fig. 6 gezeigten Ausführungsbeispiel ist der Stromeingang der als MOSFET ausgeführten Halbleiter 68 mit der Stromeingangsplatte 61 und der Stromausgang der als MOSFET ausgeführten Halbleiter 68 mit der Stromausgangsplatte 62 verbunden. Beide Platten 61, 62 sind im Wesentlichen parallel und in geringem Abstand (Entfernung bis zu 10 mm) zueinander ausgerichtet. Hierdurch wird die Anordnung sehr kompakt. Der Stromeingang ist mittels eines Verbindungsmittels 615 durch Löten oder Sintern unmittelbar mit der Stromeingangsplatte 61 elektrisch leitend verbunden. Hierzu wird am Stromeingang des Halbleitergehäuses 67 Lot oder Sinterpaste als Verbindungsmittel 615 flächig aufgetragen. Die der Außenseite des Halbleitergehäuses 67 zugewandte Innenfläche der Stromeingangsplatte 61 ist, abgesehen von den Kontaktstellen mit dem Halbleitergehäuse 67, mit einem Lack (hier nicht gezeigt) versehen, welcher das Verbindungsmittel 615, wie Lot oder Sintermaterial, abstößt. Der Stromausgang ist mit der Stromausgangsplatte 62 mittelbar mittels elektrischer Verbindungsmittel 614 (VIAS = vertikale Durchkontaktierungen durch den Bauteilträger 69) und/oder mittels Kupferdomen (nicht gezeigt), welche Bestandteil der Stromausgangsplatte 62 sein können, elektrisch leitend verbunden. Auch hier kann ein Lack 610 vorgesehen sein.

Das Gate 66 der als MOSFET ausgeführten Halbleiter 68 ist zwischen den Platten 61, 62 zugänglich, so dass es mittels einer Ansteuerschaltung (nicht gezeigt) ansteuerbar ist oder an einen Anschluss (nicht gezeigt) für eine Ansteuerschaltung angebunden werden kann.

Die parallel und in ihrem Randbereich bündig zueinander angeordneten Platten 61, 62 sind mindestens in ihrem Randbereich mittels eines elektrisch nicht leitfähigen Platten-Verbindungsmittels 63 miteinander verbunden, so dass die Platten 61, 62 mit dem Verbindungsmittel 63 ein Gehäuse für den Halbleiter 68 bilden. Das Verbindungsmittel 63 kann eine Vergussmasse sein, es kann alternativ jedoch auch mittels eines Kunststoffes (z.B. Hartkunststoff oder Weichkunststoff) realisiert sein. Vorteil ist die dadurch erzielbare mechanische Festigkeit der Anordnung bei verbesserter Wärmeleitung und bei geringer thermischer Dehnung und der Schutz der Lötstellen, die bei den Verbindungsmitteln 615 gebildet sind, und der Halbleiter 68.

Mittels des Verbindungsmittels 63 kann eine Anordnung realisiert werden, welche je nach Anwendung auch den für die Verwendung erforderlichen IP-Schutzarten genügt.

Der während des Betriebs der Anordnung von Fig, 6 auftretende Strom 616 kann mittels der Steueranschlüsse 66 gesteuert werden und so die vorgegebene Richtung von der Stromeingangsplatte 61 zur Stromausgangsplatte 62 passieren. Der Wärmestrom, welcher von den Halbleitern 68 aufgrund des während des Betriebs der Anordnung in den Halbleitern 68 auftretenden elektrischen Stromes verursacht wird und durch Pfeile 65 veranschaulicht ist, kann dagegen in beiden Richtungen von der Stromeingangsplatte 61 und der Stromausgangsplatte 62 und damit von den Halbleitern 68 abtransportiert werden. Dieses Verhalten soll mittels der gezeigten Pfeile 65 angedeutet sein. Das Verhalten ist insbesondere vorteilhaft beim Widerstandsschweißen, wo sehr hohe Ströme zum Einsatz kommen und entsprechend viel Verlustwärme abgeführt werden muss, aber auch bei vergleichbaren Anwendungen.

In Fig. 6 sind vier Halbleiter 68 gezeigt. Die Stromeingänge dieser Halbleiter 68 sind mittels der Platte 61 miteinander verbunden. Ebenso sind die Stromausgänge mittels der Platte 62 miteinander verbunden.

Die in Fig. 6 gezeigte Ausführungsform ist lediglich grob schematisch zu sehen und soll keine Begrenzung der Anzahl der verwendeten Halbleiter 68 auf lediglich vier Halbleiter 68 nahelegen. Im Prinzip können beliebig viele Halbleiter 68 auf diese Weise vorgesehen werden, um somit die von der Anordnung mittels der beschriebenen Parametrierung steuerbare Strommenge zu beeinflussen. Je mehr Halbleiter 68 parallel geschaltet werden, desto größer ist die Leistungsfähigkeit der in Fig. 6 dargestellten Anordnung im Hinblick auf den steuerbaren Strom. Bei den Halbleitern 68 kann es sich um Einzelhalbleiter handeln oder um Halbleitergruppen, die wiederum in sich erfindungsgemäß parametrierbar sein können.

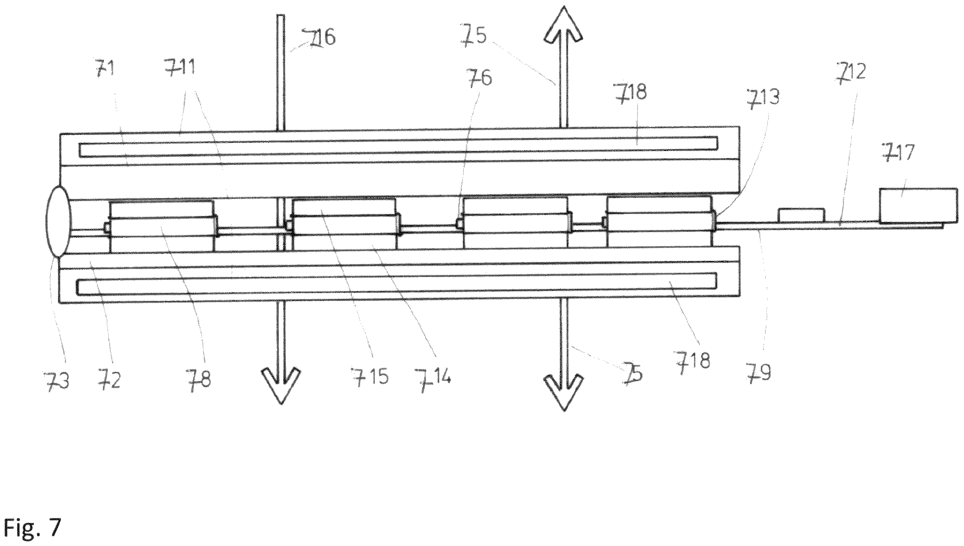

Fig. 7 zeigt eine Anordnung, die ähnlich der bereits in Fig. 6 gezeigten Anordnung ist. Der Hauptunterschied von Fig. 7 zur Fig. 6 besteht darin, dass die Stromeingänge (z.B. Oberseite oder Unterseite der Halbleiter) und die Stromausgänge (z.B. Oberseite oder Unterseite der Halbleiter) mittels Verbindungsmittel 714, 715 zum Löten oder Sintern unmittelbar mit den Platten 71, 72, also direkt, verbunden sind. Hier sind keine elektrischen Verbindungsmittel wie VIAS oder ähnliches vorhanden, die in Fig. 6 gezeigt sind. Die Steueranschlüsse 76 sind in Fig. 7 mittels Leiterbahnen z.B. auf einer Folie oder auf einem starren Träger 79 zugänglich angeordnet und können mittels einer Ansteuerkomponente 717 angesteuert werden. Ein weiterer Unterschied zwischen der Anordnung aus Fig. 7 und Fig. 6 besteht darin, dass beide Platten 71, 72 in Fig. 7 jeweils mit einer mit Kühlkanälen 718 durchsetzten Zusatzkühlplatte 711 verbunden sind. Diese Kühlplatten 711 könnten auch bei der in Fig. 6 gezeigten Variante Verwendung finden. Auch könnte nur eine Kühlplatte 711 an der Stromeingangsplatte 71 oder an der Stromausgangsplatte 72 vorgesehen sein. Prinzipiell könnte bei beiden Varianten gemäß Fig. 6 und Fig. 7 auch eine Stromeingangsplatte 71 und/oder eine Stromausgangsplatte 72 mit einem integrierten Kühlkanal 718 verwendet werden, so dass die separaten Zusatzkühlplatten 711 entfallen können. Die möglichen Varianten hängen in erster Linie vom Leistungsbedarf des Anwendungsfalles ab.

Im Randbereich rechts in Fig. 7 ragt hier mittels einer Aussparung im Verbindungsmittel (nicht gezeigt) ein Leiterplattenteil 712 aus der Anordnung heraus. Es kann auch ein zweiter Bauteilträger (nicht gezeigt) mit dem ersten Bauteilträger 79 mittels einer Steckverbindung 713 mechanisch und/oder elektrisch verbunden werden. Diese aus der Anordnung herausragende Leiterplatte 712 umfasst Komponenten 717 zur gemeinsamen Ansteuerung/Parametrierung der zwischen den Platten 71, 72 als Halbleiter-Parallelschaltung 78. Das Verbindungsmittel 73 schließt die PlattenAnordnung oder Scheibenzelle ringsherum ab. Im Bereich der Aussparung (rechts im Bild) wird die Anordnung vergossen, so dass die Vergussmasse zusammen mit dem umlaufenden Verbindungsmittel einen gegenüber äußeren widrigen Einflüssen schützenden Abschluss der Anordnung bildet. Bei Verwendung geeigneter Miniaturbauteile ist es auch möglich, die Komponente 717 auf dem ersten Bauteilträger 79 anzubringen, so dass auch die Komponente 717 von den Platten 71, 72 und dem Verbindungsmittel 73 vollständig umschlossen sind. Diese Variante wird bei der Serienproduktion der Anordnung empfohlen, da hierdurch eine besonders sichere und stabile Ausführungsform erzielt wird.

Empfohlen wird auch hier ein möglichst dünner Bauteilträger 79, so dass die Anordnung aus Widerstandsdiode und Komponente 717 sehr leicht und material- und damit ressourcensparend ausgestaltet ist, wobei beachtet werden sollte, dass die mechanischen Eigenschaften des Bauteilträgers 79 zum Tragen der Halbleiter und zur Stabilisierung der Anordnung gerade noch ausreichen. Die Bezugszeichen 716 und 75 bezeichnen wie in Figur 6 den Strom und die Wärme.

Alle zuvor beschriebenen Ausgestaltungen der Leistungsbauteile 10, 55 und des Verfahrens können einzeln oder in allen möglichen Kombinationen Verwendung finden. Insbesondere können alle Merkmale und/oder Funktionen der zuvor beschriebenen Ausführungsbeispiele beliebig kombiniert oder auch weggelassen werden. Zusätzlich sind insbesondere folgende Modifikationen denkbar.

Die in den Figuren dargestellten Teile sind schematisch dargestellt und können in der genauen Ausgestaltung von den in den Figuren gezeigten Formen abweichen, solange deren zuvor beschriebenen Funktionen gewährleistet sind.

Die Halbleiterstromventile 14₁, 14₂, 14₃ können auch andere Halbleiterelemente sein, die ähnlich zu MOSFET sind, welche Drain D, Source S und Gate G aufweisen, oder ähnlich zu IGBTs sind, welche Kollektor K, Emitter E und Gate G aufweisen. Mittels der Halbleiterstromventile 14₁, 14₂, 14₃ sollte jedoch in allen Fällen ein Strom vorzugsweise mittels einer elektrischen Potentialdifferenz aktiv steuerbar sein.

Die in Fig. 1 bis Fig. 7 gezeigten Merkmale können auch in abgewandelter Form zur Realisierung alternativer Ausführungsformen fachmännisch zusammengefasst werden. Auch können alternative Ausführungsformen zusätzliche in der Beschreibung genannte Merkmale umfassen, welche in der Figurenbeschreibung nicht gezeigt sind.

## Patentansprüche

1. Leistungsbauteil (10, 55) zur Bereitstellung eines elektrischen Starkstromes (I2), mit mehreren Halbleiterstromventilen (14₁, 14₂, 14₃), welche jeweils einen Stromeingang (D), einen Stromausgang (S) und einen Steueranschluss (G) zum Steuern des Stromes zwischen Stromeingang (D) und Stromausgang (S) umfassen, wobei die Halbleiterstromventile (14₁, 14₂, 14₃) gleichzeitig parallel betreibbar sind, und mit einem Schaltmittel (17₁, 17₂, 17₃), welches derart mit den Halbleiterstromventilen (14₁, 14₂, 14₃) verschaltet ist, dass mittels eines Schaltmittelzustandes, der mit einem parametrierbaren Register festgelegt ist, die Anzahl der Halbleiterstromventile (14₁, 14₂, 14₃) einstellbar ist, welche parallel zur Steuerung der Stärke des Stromes (I2) betrieben werden.

2. Leistungsbauteil (10, 55) nach Anspruch 1, wobei ein Anschlussmittel (S1 bis S3; S1 bis S4) für eine Einrichtung (20) vorgesehen ist, mittels welcher der Zustand des Schaltmittels (17₁, 17₂, 17₃) steuerbar ist.

3. Leistungsbauteil (10, 55) nach einem der vorhergehenden Ansprüche, wobei das Schaltmittel (17₁, 17₂, 17₃) am Steueranschluss (G) vorgesehen ist, so dass die Stromzufuhr zum Steueranschluss (G) mittels des Schaltzustandes des Schaltmittels (17₁, 17₂, 17₃) steuerbar ist.

4. Leistungsbauteil (10, 55) nach einem der vorhergehenden Ansprüche, wobei das Schaltmittel (17₁, 17₂, 17₃), insbesondere zusätzlich auch, am Stromeingang (D) vorgesehen ist, so dass der Stromfluss über den Stromeingang (D) mittels des Schaltzustandes des Schaltmittels (17₁, 17₂, 17₃) steuerbar ist.

5. Leistungsbauteil (10, 55) nach einem der vorhergehenden Ansprüche, wobei das Schaltmittel (17₁, 17₂, 17₃), insbesondere zusätzlich auch, am Stromausgang (S) vorgesehen ist, so dass der Stromfluss über den Stromausgang (S) mittels des Schaltzustandes des Schaltmittel (17₁, 17₂, 17₃) steuerbar ist.

6. Leistungsbauteil (10, 55) nach einem der vorhergehenden Ansprüche, mit mindestens einem Treiber (15) zur Versorgung des Steueranschlusses (G) mit einem Steuerstrom, wobei vorzugsweise ein elektrischer Widerstand (16₁, 16₂, 16₃) zwischen Treiberausgang (15) und Steueranschluss (G) vorgesehen ist.

7. Leistungsbauteil (10, 55) nach einem der vorangehenden Ansprüche, wobei die mindestens zwei Halbleiterstromventile (14₁, 14₂, 14₃) MOSFET-Bauteile oder IGBT-Bauteile oder dergleichen sind.

8. Leistungsbauteil (10, 55) nach einem der vorangehenden Ansprüche, wobei ein Halbleiterstromventil (14₁, 14₂, 14₃) mittels einer Halbleiterstromventilgruppe (14₂₁, 14₂₂, 14₂₃) realisiert ist, wobei von einer Halbleiterstromventilgruppe (14₂₁, 14₂₂, 1423) mindestens zwei parallel geschaltete einzelne Stromventile umfasst sind, welche gemeinsam mittels des Steueranschlusses (G) ansteuerbar sind.

9. Leistungsbauteil (10, 55) nach einem der vorangehenden Ansprüche 2 bis 8, mit einer Einrichtung (20) zur Steuerung des Zustandes des Schaltmittels (17₁, 17₂, 17₃) und/oder mit einem Busanschluss (19) zum Anschluss des Leistungsbauteils (10; 55) an eine externe Einrichtung (20) zur Steuerung des Zustandes des Schaltmittels (17₁, 17₂, 17₃), wobei die Einrichtung (20) zum Ausgeben eines digitalen Steuersignals (18) an das Schaltmittel (17₁, 17₂, 17₃) und/oder das Anschlussmittel (S1 bis S3; S1 bis S4) ausgestaltet ist.

10. Leistungsbauteil (10, 55) gemäß einem der vorangehenden Ansprüche, umfassend eine Stromeingangsplatte (61, 71) zum Einspeisen eines Eingangsstroms (I1), und mit einer Stromausgangsplatte (62, 72) zur Bereitstellung des elektrischen Starkstromes (I2), wobei die Halbleiterstromventile (14₁, 14₂, 14₃) zwischen der Stromeingangsplatte (61, 71) und der Stromausgangsplatte (62, 72) angeordnet sind und wobei die Stromeingänge (D) mit der Stromeingangsplatte (61, 71) und die Stromausgänge (S) mit der Stromausgangsplatte (62, 72) verbunden sind, wobei die Steueranschlüsse (G) zwischen beiden Platten (69, 79) angeordnet sind.

11. Leistungsbauteil (10, 55) gemäß einem der vorangehenden Ansprüche 2 bis 10, wobei die Halbleiterstromventile (14₁, 14₂, 14₃), die Schaltmittel (17₁, 17₂, 17₃), und vorzugsweise die Einrichtung (20) und besonders bevorzugt auch das Anschlussmittel (S1 bis S3; S1 bis S4) an einem Bauteilträger (69, 79) angeordnet sind, welcher Leiterbahnen umfasst, mittels derer die vom Bauteilträger (69, 79) umfassten Komponenten miteinander verschaltet sind.

12. Leistungsbauteil (10, 55) gemäß Anspruch 11, wobei der Bauteilträger (69, 79) zwischen der Stromeingangsplatte (61, 71) Stromausgangsplatte (62, 72) in Sandwich-Bauweise angeordnet ist, wobei vorzugsweise der Zwischenraum der Anordnung insbesondere im Randbereich verschlossen ist.

13. Leistungsbauteil (10, 55) gemäß einem der Ansprüche 9 bis 12, wobei von der Einrichtung (20) ein Webserver zum Bereitstellen einer Konfigurationsoberfläche zum Konfigurieren der Schaltstellungen der Schaltmittel (17₁, 17₂, 17₃) umfasst ist.

14. Leistungsbauteil (10, 55) gemäß einem der Ansprüche 9 bis 13, wobei die Einrichtung (20) vorzugsweise mittels Internetprotokollen, vorzugsweise mittels eines Busses, drahtgebunden oder drahtlos mit übergeordneten Steuerungen kommunizieren kann und insbesondere Anweisungen von übergeordneten Steuerungen ausführen kann.

15. Leistungsbauteil (10, 55) nach einem der vorangehenden Ansprüche, wobei das Leistungsbauteil (10, 55) als Scheibenzelle ausgestaltet ist oder an einem Transformator angeordnet ist.

16. Leistungsbauteil (10, 55) nach einem der vorangehenden Ansprüche für die Bereitstellung eines Schweißstromes, wobei das Leistungsbauteil (10, 55) ausgebildet ist, die Schweißstromstärke während eines Schweißprozesses mittels des Schaltmittels (17₁, 17₂, 17₃) zu verändern.

17. Halbbrückenschaltung oder Vollbrückenschaltung oder Mittelpunktschaltung zur Gleichrichtung oder Umrichtung oder Wechselrichtung, umfassend ein Leistungsbauteil (10, 55) gemäß einem der vorhergehenden Ansprüche.

18. Versorgungsmodul für Servomotoren, Gleichrichter für Widerstandsschweißanlagen oder Energieversorgung für Elektrofahrzeuge, umfassend ein Leistungsbauteil (10, 55) gemäß einem der Ansprüche 1 bis 16.

19. Verfahren zur Adaptierung der Leistungsfähigkeit eines Leistungsbauteils (10, 55) an einen Anwendungsfall, wobei das Leistungsbauteil (10, 55) mehrere Halbleiterstromventile (14₁, 14₂, 14₃) aufweist, wobei die Halbleiterstromventile (14₁, 14₂, 14₃) gleichzeitig parallel betreibbar sind, wobei das Verfahren den Schritt eines elektronischen Parametrierens der Parallelschaltung aufweist, wobei der Schritt des elektronischen Parametrierens mittels eines Schaltmittels (17₁, 17₂, 17₃) des Leistungsbauteils (10, 55) durch Schalten zumindest eines der Halbleiterstromventile (14₁, 14₂, 14₃) in einen leitenden oder in einen nicht-leitenden Zustand durchgeführt wird, wobei ein Schaltmittelzustand verwendet wird, der mit einem parametrierbaren Register festgelegt ist.

20. Verfahren gemäß Anspruch 19, wobei das elektronische Parametrieren mittels mindestens einen Anschluss (S1 bis S3; S1 bis S4) des Leistungsbauteils (10; 55) erfolgt.

21. Verfahren gemäß einem der vorhergehenden Verfahrensansprüche, wobei das elektronische Parametrieren von einer Einrichtung (20) ausgeführt wird, welche vorzugsweise vom Leistungsbauteil (10, 55) umfasst ist.

22. Verfahren gemäß einem der vorhergehenden Verfahrensansprüche, wobei mittels der elektronischen Parametrierung defekte Halbleiterstromventile (14₁, 14₂, 14₃) abgeschaltet werden.

## Claims

1. Power component (10, 55) for providing an electrical heavy current (12), comprising a plurality of semiconductor current valves (14₁, 14₂, 14₃), each comprising a current input (D), a current output (S) and a control connection (G) for controlling the current between current input (D) and current output (S), wherein the semiconductor current valves (14₁, 14₂, 14₃) are operable simultaneously in parallel, and comprising a switching means (17₁, 17₂, 17₃), which is interconnected with the semiconductor current valves (14₁, 14₂, 14₃) in such a way that the number of semiconductor current valves (14₁, 14₂, 14₃) which are operated in parallel for controlling the intensity of the current (12) is settable by means of a switching means state defined with a parametrizable register.

2. Power component (10, 55) according to Claim 1, wherein provision is made of a connection means (S1 to S3; S1 to S4) for a device (20) by means of which the state of the switching means (17₁, 17₂, 17₃) is controllable.

3. Power component (10, 55) according to either of the preceding claims, wherein the switching means (17₁, 17₂, 17₃) is provided at the control connection (G), such that the current supplied to the control connection (G) is controllable by means of the switching state of the switching means (17₁, 17₂, 17₃) .

4. Power component (10, 55) according to any of the preceding claims, wherein the switching means (17₁, 17₂, 17₃), in particular additionally also, is provided at the current input (D), such that the current flow via the current input (D) is controllable by means of the switching state of the switching means (17₁, 17₂, 17₃).

5. Power component (10, 55) according to any of the preceding claims, wherein the switching means (17₁, 17₂, 17₃), in particular additionally also, is provided at the current output (S), such that the current flow via the current output (S) is controllable by means of the switching state of the switching means (17₁, 17₂, 17₃) .

6. Power component (10, 55) according to any of the preceding claims, comprising at least one driver (15) for supplying the control connection (G) with a control current, wherein an electrical resistor (16₁, 16₂, 16₃) is preferably provided between driver output (15) and control connection (G).

7. Power component (10, 55) according to any of the preceding claims, wherein the at least two semiconductor current valves (14₁, 14₂, 14₃) are MOSFET components or IGBT components or the like.

8. Power component (10, 55) according to any of the preceding claims, wherein a semiconductor current valve (14₁, 14₂, 14₃) is realized by means of a semiconductor current valve group (14₂₁, 14₂₂, 14₂₃), wherein a semiconductor current valve group (14₂₁, 14₂₂, 14₂₃) comprises at least two individual current valves which are connected in parallel and which are jointly drivable by means of the control connection (G).

9. Power component (10, 55) according to any of the preceding Claims 2 to 8, comprising a device (20) for controlling the state of the switching means (17₁, 17₂, 17₃) and/or comprising a bus connection (19) for connecting the power component (10; 55) to an external device (20) for controlling the state of the switching means (17₁, 17₂, 17₃), wherein the device (20) is configured for outputting a digital control signal (18) to the switching means (17₁, 17₂, 17₃) and/or the connection means (S1 to S3; S1 to S4).

10. Power component (10, 55) according to any of the preceding claims, comprising a current input plate (61, 71) for feeding in an input current (II), and comprising a current output plate (62, 72) for providing the electrical heavy current (12), wherein the semiconductor current valves (14₁, 14₂, 14₃) are arranged between the current input plate (61, 71) and the current output plate (62, 72) and wherein the current inputs (D) are connected to the current input plate (61, 71) and the current outputs (S) are connected to the current output plate (62, 72), wherein the control connections (G) are arranged between the two plates (69, 79).

11. Power component (10, 55) according to any of the preceding Claims 2 to 10, wherein the semiconductor current valves (14₁, 14₂, 14₃), the switching means (17₁, 17₂, 17₃), and preferably the device (20) and particularly preferably also the connection means (S1 to S3; S1 to S4) are arranged on a component carrier (69, 79) comprising conductor tracks by means of which the component parts comprised by the component carrier (69, 79) are interconnected with one another.

12. Power component (10, 55) according to Claim 11, wherein the component carrier (69, 79) is arranged between the current input plate (61, 71) and the current output plate (62, 72) in a sandwich design, wherein the interspace of the arrangement is preferably closed particularly in the edge region.

13. Power component (10, 55) according to any of Claims 9 to 12, wherein the device (20) comprises a web server for providing a configuration interface for configuring the switching positions of the switching means (17₁, 17₂, 17₃) .

14. Power component (10, 55) according to any of Claims 9 to 13, wherein the device (20) can communicate with superordinate controllers in a wired or wireless manner preferably by means of internet protocols, preferably by means of a bus, and can execute in particular instructions from superordinate controllers.

15. Power component (10, 55) according to any of the preceding claims, wherein the power component (10, 55) is embodied as a disc-type thyristor or is arranged on a transformer.

16. Power component (10, 55) according to any of the preceding claims for providing a welding current, wherein the power component (10, 55) is designed to vary the welding current intensity during a welding process by means of the switching means (17₁, 17₂, 17₃).

17. Half-bridge circuit or full-bridge circuit or mutual-point circuit for rectification or conversion or inversion, comprising a power component (10, 55) according to any of the preceding claims.

18. Supply module for servomotors, rectifiers for resistance welding installations or energy supply for electric vehicles, comprising a power component (10, 55) according to any of Claims 1 to 16.

19. Method for adapting the performance of a power component (10, 55) to an application, wherein the power component (10, 55) has a plurality of semiconductor current valves (14₁, 14₂, 14₃), wherein the semiconductor current valves (14₁, 14₂, 14₃) are operable simultaneously in parallel, wherein the method comprises the step of electronic parametrization of the parallel circuit, wherein the step of electronic parametrization is carried out by means of a switching means (17₁, 17₂, 17₃) of the power component (10, 55) by at least one of the semiconductor current valves (14₁, 14₂, 14₃) being switched into a conducting state or into a non-conducting state, wherein a switching means state defined with a parametrizable register is used.

20. Method according to Claim 19, wherein the electronic parametrization is effected by means of at least one connection (S1 to S3; S1 to S4) of the power component (10; 55).

21. Method according to any of the preceding method claims, wherein the electronic parametrization is performed by a device (20) that is preferably comprised by the power component (10, 55).

22. Method according to any of the preceding method claims, wherein defective semiconductor current valves (14₁, 14₂, 14₃) are turned off by means of the electronic parametrization.

## Revendications

1. Composant de puissance (10, 55) destiné à fournir un courant électrique de puissance (12), comportant plusieurs soupapes de courant à semi-conducteurs (14₁, 14₂, 14₃), comprenant chacune une entrée de courant (D), une sortie de courant (S) et une borne de commande (G) pour commander le courant entre l'entrée de courant (D) et la sortie de courant (S), dans lequel les valves de courant à semi-conducteurs (14₁, 14₂, 14₃) peuvent être utilisées simultanément en parallèle, et comprenant un moyen de commutation (17₁, 17₂, 17₃) qui est relié aux valves de courant à semi-conducteurs (14₁, 14₂, 14₃) de telle sorte que le nombre de valves de courant à semi-conducteurs (14₁, 14₂, 14₃) qui sont utilisées en parallèle pour commander l'intensité du courant (12) peut être réglé au moyen d'un état du moyen de commutation qui est défini à l'aide d'un registre paramétrable.

2. Composant de puissance (10, 55) selon la revendication 1, dans lequel il est prévu un moyen de connexion (S1 à S3 ; S1 à S4) destiné à un dispositif (20) au moyen duquel l'état du moyen de commutation (17₁, 17₂, 17₃) peut être commandé.

3. Composant de puissance (10, 55) selon l'une des revendications précédentes, dans lequel le moyen de commutation (17₁, 17₂, 17₃) est prévu sur la borne de commande (G) de telle sorte que l'alimentation en courant de la borne de commande (G) peut être commandée au moyen de l'état de commutation du moyen de commutation (17₁, 17₂, 17₃).

4. Composant de puissance (10, 55) selon l'une des revendications précédentes, dans lequel le moyen de commutation (17₁, 17₂, 17₃) est prévu, en particulier également de manière supplémentaire, au niveau de l'entrée de courant (D), de telle sorte que le flux de courant passant par l'entrée de courant (D) peut être commandé au moyen de l'état de commutation du moyen de commutation (17₁, 17₂, 17₃).

5. Composant de puissance (10, 55) selon l'une des revendications précédentes, dans lequel les moyens de commutation (17₁, 17₂, 17₃) sont prévus, en particulier également de manière supplémentaire, au niveau de la sortie de courant (S), de telle sorte que le flux de courant passant par la sortie de courant (S) peut être commandé au moyen de l'état de commutation du moyen de commutation (17₁, 17₂, 17₃).

6. Composant de puissance (10, 55) selon l'une des revendications précédentes, comprenant au moins un circuit d'attaque (15) destiné à alimenter la borne de commande (G) avec un courant de commande, dans lequel une résistance électrique (16₁, 16₂, 16₃) est de préférence prévue entre la sortie du circuit d'attaque (15) et la borne de commande (G).

7. Composant de puissance (10, 55) selon l'une des revendications précédentes, dans lequel lesdites au moins deux valves de courant à semi-conducteurs (14₁, 14₂, 14₃) sont des composants MOSFET ou des composants IGBT ou similaires.

8. Composant de puissance (10, 55) selon l'une des revendications précédentes, dans lequel une valve de courant à semi-conducteurs (14₁, 14₂, 14₃) est réalisée au moyen d'un groupe de valves de courant à semi-conducteurs (14₂₁, 14₂₂, 14₂₃), dans lequel au moins deux valves de courant individuelles connectées en parallèle font partie d'un groupe de valves de courant à semi-conducteurs (14₂₁, 14₂₂, 14₂₃) qui peuvent être commandées en commun au moyen de la borne de commande (G).

9. Composant de puissance (10, 55) selon l'une des revendications 2 à 8 précédentes, comprenant un dispositif (20) destiné à commander l'état du moyen de commutation (17₁, 17₂, 17₃) et/ou comprenant une borne de bus (19) destinée à connecter le composant de puissance (10 ; 55) à un dispositif externe (20) destiné à commander l'état du moyen de commutation (17₁, 17₂, 17₃), dans lequel le dispositif (20) est conçu pour délivrer un signal de commande numérique (18) au moyen de commutation (17₁, 17₂, 17₃) et/ou au moyen de connexion (S1 à S3 ; S1 à S4).

10. Composant de puissance (10, 55) selon l'une des revendications précédentes, comprenant une carte d'entrée de courant (61, 71) destinée à fournir un courant d'entrée (11), et comportant une carte de sortie de courant (62, 72) destinée à fournir le courant électrique de puissance (12),
dans lequel lesdites valves de courant à semi-conducteurs (14₁, 14₂, 14₃) sont disposées entre la carte d'entrée de courant (61, 71) et la carte de sortie de courant (62, 72), et dans lequel les entrées de courant (D) sont reliées à la carte d'entrée de courant (61, 71) et les sorties de courant (S) sont reliées à la carte de sortie de courant (62, 72), dans lequel les bornes de commande (G) sont disposées entre les deux cartes (69, 79).

11. Composant de puissance (10, 55) selon l'une des revendications 2 à 10 précédentes, dans lequel les valves de courant à semi-conducteurs (14₁, 14₂, 14₃), les moyens de commutation (17₁, 17₂, 17₃), et de préférence le dispositif (20) et de manière particulièrement préférée également le moyen de connexion (S1 à S3 ; S1 à S4) sont disposés sur un support de composants (69, 79) qui comprend des pistes conductrices au moyen desquelles les composants faisant partie du support de composants (69, 79) sont connectés les uns aux autres.

12. Composant de puissance (10, 55) selon la revendication 11, dans lequel le support de composants (69, 79) est disposé entre la carte d'entrée de courant (61, 71) et la carte de sortie de courant (62, 72) sous la forme d'une structure en sandwich, dans lequel l'espace intermédiaire de l'agencement est de préférence fermé, en particulier dans la zone de bord.

13. Composant de puissance (10, 55) selon l'une des revendications 9 à 12, dans lequel le dispositif (20) comprend un serveur Web destiné à fournir une interface de configuration pour configurer les positions de commutation des moyens de commutation (17₁, 17₂, 17₃).

14. Composant de puissance (10, 55) selon l'une des revendications 9 à 13, dans lequel le dispositif (20) peut communiquer avec des unités de commande de niveau supérieur, de préférence au moyen de protocoles Internet, de préférence au moyen d'un bus, de manière câblée ou sans fil, et peut en particulier exécuter des instructions d'unités de commande de niveau supérieur.

15. Composant de puissance (10, 55) selon l'une des revendications précédentes, dans lequel le composant de puissance (10, 55) est réalisé sous la forme d'un disque semi-conducteur ou est disposé sur un transformateur.

16. Composant de puissance (10, 55) selon l'une des revendications précédentes pour la fourniture d'un courant de soudage, dans lequel le composant de puissance (10, 55) est conçu pour modifier l'intensité du courant de soudage pendant un processus de soudage au moyen du moyen de commutation (17₁, 17₂, 17₃).

17. Circuit en demi-pont ou en pont complet ou circuit à point central destiné à fonctionner comme redresseur, comme convertisseur ou comme onduleur, comprenant un composant de puissance (10, 55) selon l'une des revendications précédentes.

18. Module d'alimentation pour des servomoteurs, des redresseurs destinés à des installations de soudage par résistance ou à une alimentation en énergie destinée à des véhicules électriques, comprenant un composant de puissance (10, 55) selon l'une des revendications 1 à 16.

19. Procédé d'adaptation des performances de puissance d'un composant de puissance (10, 55) à une application, dans lequel le composant de puissance (10, 55) comprend une pluralité de valves de puissance à semi-conducteurs (14₁, 14₂, 14₃), dans lequel les valves de courant à semi-conducteurs (14₁, 14₂, 14₃) peuvent être utilisées simultanément en parallèle, dans lequel le procédé comprend l'étape consistant à paramétrer électroniquement la connexion en parallèle, dans lequel l'étape de paramétrage électronique est effectuée au moyen d'un moyen de commutation (17₁, 17₂, 17₃) du composant de puissance (10, 55) par commutation d'au moins l'une des valves de courant à semi-conducteurs (14₁, 14₂, 14₃) dans un état conducteur ou dans un état non conducteur, dans lequel on utilise un état du moyen de commutation qui est défini à l'aide d'un registre paramétrable.

20. Procédé selon la revendication 19, dans lequel le paramétrage électronique est effectué au moyen d'au moins une borne (S1 à S3 ; S1 à S4) du composant de puissance (10 ; 55).

21. Procédé selon l'une des revendications de procédé précédentes, dans lequel le paramétrage électronique est effectué par un dispositif (20) qui fait de préférence partie du composant de puissance (10 ; 55).

22. Procédé selon l'une des revendications de procédé précédentes, dans lequel des valves de courant à semi-conducteurs (14₁, 14₂, 14₃) défectueuses sont désactivées au moyen du paramétrage électronique.
